# EUROPEAN PATENT SPECIFICATION

(11) **EP 0 651 440 B1**
(45) Date of publication and mention of the grant of the patent: **23.05.2001**
(21) Application number: 93830435.9
(22) Date of filing: 29.10.1993
(51) Int. Cl.: H01L 23/433

(54) **High reliable power package for an electronic semiconductor circuit**
Leistungsverpackung mit hoher Zuverlässigkeit für eine elektronische Halbleiterschaltung
Empaquetage de puissance à haute fiabilité pour un circuit semi-conducteur électronique

(43) Date of publication of application: 03.05.1995
(73) Proprietor: STMicroelectronics S.r.l., 20041 Agrate Brianza (Milano) (IT)
(72) Inventor: Cellai, Marino, c/o SGS-THOMSOM MICROELC. Srl, I-20041 Agrate Brianza (MI) (IT); Magni, Pierangelo, c/o SGS-THOMSOM MICROELC. Srl, I-20041 Agrate Brianza (MI) (IT)
(74) Representative: Botti, Mario

(56) References cited:
- US-A- 4 066 839
- PATENT ABSTRACTS OF JAPAN vol. 016, no. 192 (E-1199)11 May 1992 & JP-A-04 027 145 (SEIKO EPSON CORP.) 30 January 1992

## Description

### Field of the invention

The present invention relates to an improved chip package containing a semiconductor integrated circuit.

More specifically, the present invention relates to a chip package incorporating in a body shell of synthetic plastic material:
- an integrated electronic circuit in a semiconductor chip mounted on a chip support frame, and
- a heat dissipating element in contact with the chip support frame.

### Prior art

As known, in the specific field of application of the present invention there is normally a requirement for equipping the circuit chip with a heat dissipating device.

The heat dissipating device is nothing but a metal slug or in any case a good heat conductor having a mass decidedly greater than that of the circuit chip and is placed in contact with the latter to facilitate dispersion of heat during operation of the circuit.

The typical structure of a chip package equipped with a heat dissipating device provides that the circuit chip be housed and constrained on a central portion of a frame consisting of a thin metal lamina.

The circuit chip and frame are in contact along the surface of the semiconductor substrate while the integrated circuit is exposed on the open surface of the circuit chip. The central portion of the frame is also connected to the heat dissipating element on the side opposite the circuit chip.

In addition, in the frame are formed in a piece a plurality of connectors consisting essentially of contact pins which, after completion of the production process, allow mounting and connecting of the circuit chip on a printed electronic circuit board. Around the circuit chip are provided predetermined contact points (pads) to which lead circuit structure terminations. Between said pads and the internal ends of the corresponding pins are connected thin wires.

Finally, the metal frame, integrated circuit chip and heat dissipating element are enclosed in a monolithic body shell provided by injection molding with an electrically insulating material, e.g. epoxy resin.

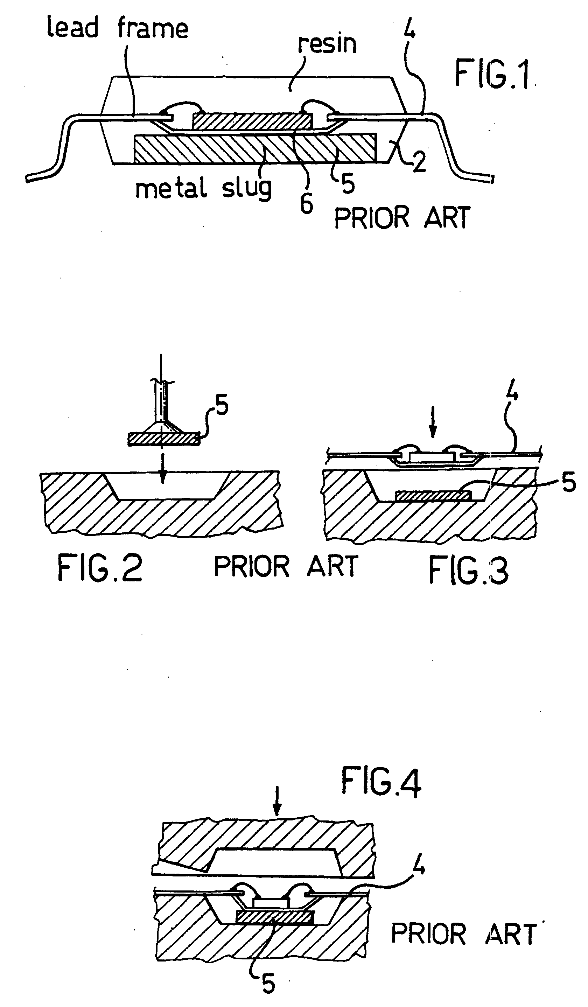

The final result of this series of operations is shown diagramatically in the annexed FIG. 1 which shows an enlarged cross section of an embodiment of a chip package provided in conformity with the known art. In FIG. 1 it is seen that a major surface of the heat dissipating element appears on the surface of the resin shell.

To further clarify the aspects of the invention it is useful to examine briefly the phases of a known type of production process leading to the production of a chip package and known as the 'drop-in process'.

The heat dissipating element is dropped into and housed in the bottom of a cavity made in the lower half of a thermosetting resin injection mold.

The chip support frame is rested on the edges of the cavity in such a manner that its slightly lowered central portion makes contact with the heat dissipating element.

The top half of the mold is placed over the bottom half to allow resin injection and production of the chip package as shown in FIGS. 2 to 4.

A variation of this process provides that the heat dissipating element be connected to the frame before bonding of the conduction wires between the circuit chip and the pins and resin injection.

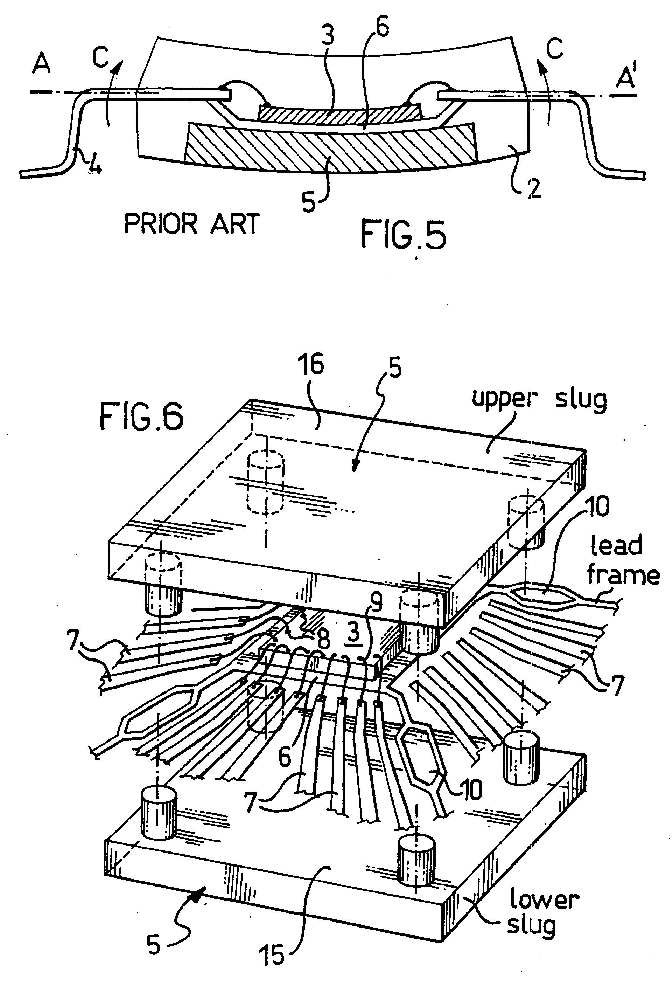

In all cases, for molding purposes the chip package has the form shown diagramatically in cross section in FIG. 5 in which it is seen that the different tensional stresses affecting the different materials involved in the production process cause bending in the direction indicated by the arrows C.

Basically, the ideal plane occupied by the chip support frame and passing through the axis A-A' undergoes bending whose consequences can be very serious for the reliability and useful life of the circuit chip.

It has been found indeed that, because of these tensional stresses, the circuit chip can break and become useless. Or the contact between the chip support frame and the heat dissipating element can break reducing the efficiency of heat dissipation with a resulting reduction in the useful life of the circuit chip.

Patent Abstracts of Japan, vol. 016, no. 192 and Japanese publication JP-A-04027 145 disclosues an electronic chip package having an electronic chip directly bonded on a lower heat radiation board. The electronic chip is then connected by gold wires to a lead frame. An upper heat radiation board is then connected to the lower heat radiation board and the resulting structure is injection molded to form the chip package.

The purpose of the present invention is to provide an improved chip package having structural and functional characteristics capable of increasing its reliability and useful life while surpassing the solutions heretofore proposed by the known art.

### Summary of the invention

The innovative idea of the present invention is based on the assumption that the presence of the heat dissipating element contributes in a decisive manner to the formation of those tensional stresses which during solidification of the thermosetting resin result in bending of the circuit chip. The heat dissipating element should therefore be positioned differently in the chip package.

On the basis of this innovative idea the purpose is achieved by a chip package defined by the annexed claim 1.

A method for increasing the reliability of a semiconductor chip package is set forth in annexed claim 10.

The characteristics and advantages of the device in conformity with the present invention are set forth in the description of an embodiment thereof given below by way of nonlimiting example with reference to the annexed drawings.

### Brief description of the drawings

In the drawings:
- FIG. 1 shows diagramatically an enlarged longitudinal cross section of a chip package provided in conformity with the known art,
- FIGS. 2 to 4 show diagramatically and in section individual phases of a production process of known type leading to the production of the chip package of FIG. 1,
- FIG. 5 shows in greater detail the structure of the chip package of FIG. 1,
- FIG. 6 shows a perspective view with detached parts of a chip package provided in conformity with the present invention,
- FIG. 7 shows diagramatically an enlarged longitudinal cross section of the chip package of FIG. 6,
- FIGS. 8 to 11 show diagramatically cross sections of the chip package during individual phases of a production process leading to provision of the chip package in conformity with the present invention,
- FIG. 12 shows an enlarged view of a detail of the example of FIG. 11, and
- FIG. 13 shows with detached parts and partial cross section the detail of FIG. 12.

### Detailed Description

With reference to the above figures, reference number 1 indicates diagramatically an entire chip package provided in conformity with the present invention.

The chip package 1 incorporates in a body shell 2 of plastic synthetic material at least one electronic circuit chip 3 on a semiconductor mounted on a support frame 4 and a heat dissipating device 5 in contact with the circuit chip 3.

The circuit chip 3 is substantially associated with a semiconductor and housed and constrained on a central portion 6 of the chip support frame 4 consisting of a thin metal lamina.

The circuit chip 3 and the chip support frame 4 are in contact along the surface of the semiconductor substrate while the circuit is exposed on the open surface of the circuit chip 3. In the chip support frame 4 are formed in one piece a plurality of connectors consisting essentially of contact pins 7 which, at the end of the production process, allow mounting and connecting the circuit chip 3 on a printed circuit board. Around the circuit chip 3 are provided predetermined contact pads 8 to which lead terminations of the circuitry structure. Between said pads 8 and the internal ends of the corresponding pins 7 are connected thin metal wires 9.

Advantageously in conformity with the present invention the heat dissipating device 5 comprises at least two structurally independent heat dissipating elements 15 and 16 in mutual contact.

Said heat dissipating elements 15 and 16 are located on opposite sides of said frame 4 and in particular are arranged symmetrically in relation to said frame.

In addition, the heat dissipating elements 15 and 16 which make up the heat dissipating device 5 are connected together in a separable manner by spacing posts 11 which traverse holes 10 made through the chip support frame 4. The posts 11 are provided with respective and opposed half-posts, i.e. half-posts 12 and 13 having shaped and conjugate ends.

The half-posts 12 and 13 project from the elements 15, 16 respectively and are formed in one piece with the corresponding heat dissipating element.

Preferably the half-posts 12 have the end 14 pointed or equipped with a mating tooth. Said end is coupled with that of the corresponding and opposed half-post 13 which has a seat 17 for receiving it.

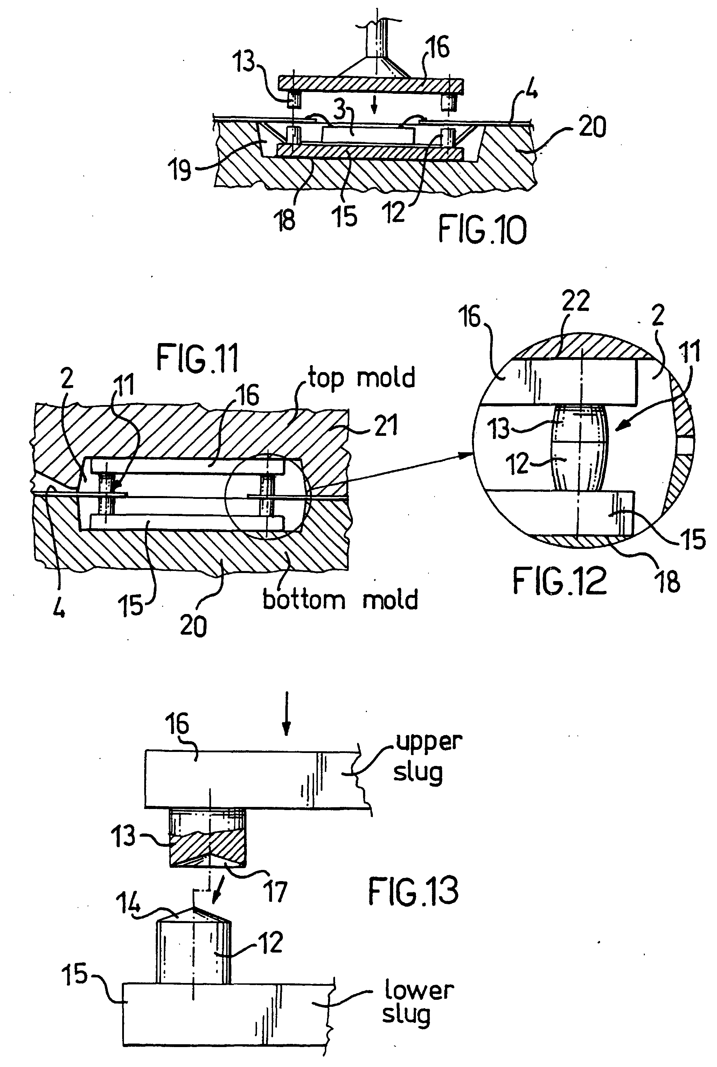

This construction peculiarity allows the half-posts 12 and 13 to be self-centring and to collapse towards self-alignment when their ends are mated as shown in FIGS. 12 and 13.

In the embodiment described here the half-posts 12 are formed in one piece and in sufficient number on the heat dissipating element 15 while the corresponding half-posts 13 are formed in the element 16. Of course there is nothing against modifying the type of half-post made on one or the other of the heat dissipating elements.

There are now described briefly the phases of the production process leading to provision of the chip package in conformity with the present invention.

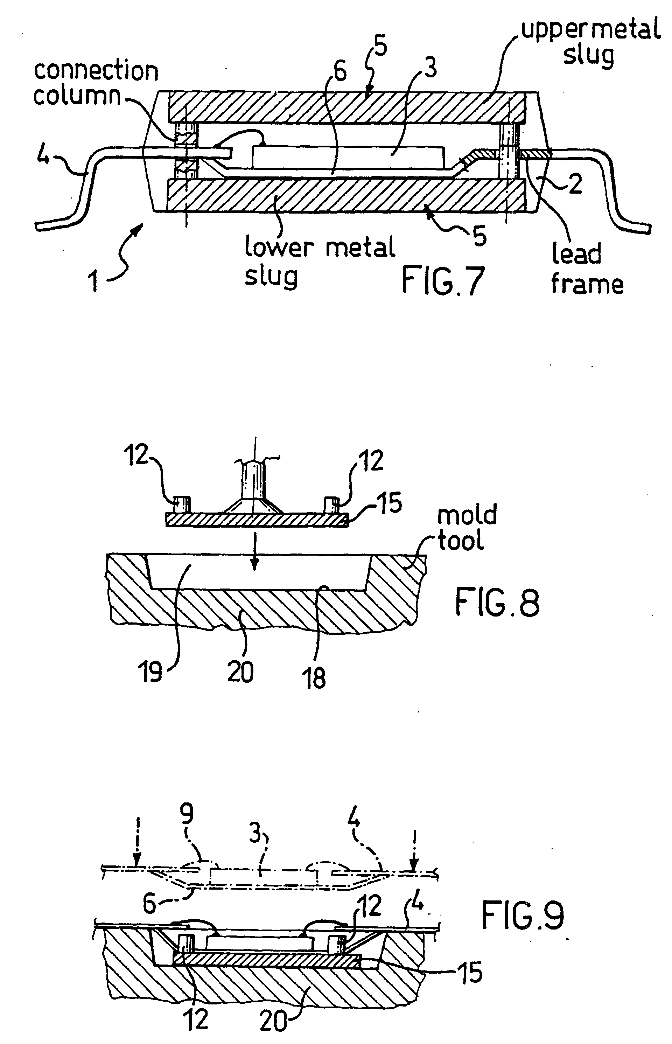

The first heat dissipating element 15 is dropped and housed in the bottom 18 of a cavity 19 made in the lower half-mold 20 of a thermosetting resin injection mold as shown in FIG. 8.

The chip support frame 4 for supporting the circuit chip 3 is rested on the edges of the cavity 19 in such a manner that the slightly lowered central portion 6 of the circuit chip 3 makes contact with the heat dissipating element 15 as shown in FIG. 9.

The second heat dissipating element element 16 is placed over the first in such a manner that the respective half-posts 12 and 13 mate to form the spacing posts 11 as shown in FIG. 12.

The upper half-mold 21 is placed over the lower half-mold 20 and rests on the top surface 22 of the heat dissipating element 16. The mold thus closed is ready for thermosetting resin injection and production of the chip package 1.

From the above description it is clear that the chip package in conformity with the present invention achieves its purpose and provides numerous advantages the first of which is the fact that the heat dissipating element has substantially a symmetrical structure in relation to the chip support frame.

This prevents formation of tensional stresses which could damage the circuit chip during solidification of the heat-hardening resin.

The structure of the chip package in conformity with the present invention also aids heat dissipation better than devices made in conformity with the known art.

Another important advantage is the fact that the coupling 11 described and illustrated here between the two opposed heat dissipating elements allows improvement of the closing of the two half-molds forming the resin injection mold and thus prevents resin burrs often present on the outer surface of the heat dissipating elements.

Modifications and variations falling within the scope of the present invention as set forth in the annexed claims can be made to the chip package in conformity with the present invention.

## Claims

1. Chip package incorporating in a body shell (2) of synthetic plastic material:
- at least one electronic circuit on a semiconductor chip (3), and
- a heat dissipating device (5)
wherein the heat dissipating device (5) comprises at least two structurally independent heat dissipating elements (15,16) in mutual contact, characterised by a chip support frame (4) on which the semiconductor chip is mounted and which is in contact with the heat dissipating device (5).

2. Chip package in conformity with claim 1 characterised in that said two heat dissipating elements (15,16) are located on opposite sides of said chip support frame (4).

3. Chip package in conformity with claim 1 characterised in that said heat dissipating elements (15,16) are arranged symmetrically in relation to said chip support frame (4).

4. Chip package in conformity with claim 1 characterised in that said heat dissipating elements (15,16) are connected in a separable manner by spacing posts (11).

5. Chip package in conformity with claim 4 characterised in that said posts (11) consist of opposed half-posts (12,13) having shaped and conjugate ends projecting from' said heat dissipating elements (15,16) respectively.

6. Chip package in conformity with claim 5 characterised in that said half-posts (12,13) are formed in a piece in each corresponding element (15,16).

7. Chip package in conformity with claim 4 characterised in that said posts (11) traverse holes (10) made through the chip support frame (4).

8. Chip package in conformity with claim 4 characterised in that said posts (11) are formed in a piece in at least one of the two heat dissipating elements (15,16).

9. Chip package in conformity with claim 5 characterised in that said half-posts (12,13) have respective self-centring ends (14,17) shaped in a complementary manner.

10. Method for increasing the reliability of a semiconductor chip package incorporating in a body shell (2) of synthetic plastic material:
- at least one circuit chip (3) mounted on a chip support frame (4), and
- heat dissipating elements (15,16) in contact with the circuit chip (3), the method comprising the steps of
- placing a first heat dissipating element (15) into a housing on the bottom (18) of a cavity (19) made in the lower half (20) of an injection mold for synthetic plastic material,
- positioning of the chip support frame (4) on the edges of the cavity (19) in such a manner that a slightly lowered central portion (6) of the chip support frame (4) makes contact with the first heat dissipating element (15),
- placing a second heat dissipating element (16) over the first heat dissipating element (15) and coupling it thereto by means of spacing posts (11).
- placing an upper half-mould (21) over the second heat dissipating element (16) and closing the mould.

## Patentansprüche

1. Chip-Baustein, der in einer Körperhülle (2) aus Kunststoffmaterial folgendes aufweist:
- wenigstens eine elektronische Schaltung auf einem Halbleiterchip (3), und
- eine Wärmeabführvorrichtung (5), wobei die Wärmeabführvorrichtung (5) wenigstens zwei strukturell voneinander unabhängige Wärmeabführelemente (15, 16) in gegenseitiger Berührung aufweist,
dadurch gekennzeichnet, daß der Halbleiterchip (3) auf einem Chipträgerrahmen (4) angebracht ist und daß der Chipträgerrahmen (4) mit der Wärmeabführvorrichtung (5) in Berührung steht.

2. Chip-Baustein nach Anspruch 1, dadurch gekennzeichnet, daß die beiden Wärmeabführelemente (15, 16) auf entgegengesetzten Seiten des Chip-trägerrahmens (4) angeordnet sind.

3. Chip-Baustein nach Anspruch 1, dadurch gekennzeichnet, daß die Wärmeabführelemente (15, 16) in Relation zu dem Chipträgerrahmen (4) symmetrisch angeordnet sind.

4. Chip-Baustein nach Anspruch 1, dadurch gekennzeichnet, daß die Wärmeabführelemente (15, 16) durch Abstandszapfen (11) trennbar miteinander verbunden sind.

5. Chip-Baustein nach Anspruch 4,
dadurch gekennzeichnet, daß die Zapfen (11) aus einander gegenüberliegenden Zapfenhälften (12, 13) bestehen, die geformte und einander zugeordnete Enden aufweisen, die von den jeweiligen Wärmeabführelementen (15, 16) wegragen.

6. Chip-Baustein nach Anspruch 5,
dadurch gekennzeichnet, daß die Zapfenhälften (12, 13) in jedem entsprechenden Element (15, 16) einstückig ausgebildet sind.

7. Chip-Baustein nach Anspruch 4,
dadurch gekennzeichnet, daß die Zapfen (11) Löcher (10) durchsetzen, die in dem Chipträgerrahmen (4) ausgebildet sind.

8. Chip-Baustein nach Anspruch 4,
dadurch gekennzeichnet, daß die Zapfen (11) in wenigstens einem der beiden Wärmeabführelemente (15, 16) einstückig ausgebildet sind.

9. Chip-Baustein nach Anspruch 5,
dadurch gekennzeichnet, daß die Zapfenhälften (12, 13) jeweilige selbstzentrierende Enden (14, 17) aufweisen, die komplementär zueinander geformt sind.

10. Verfahren zum Steigern der Zuverlässigkeit eines Halbleiterchip-Bausteins, der in einer Körperhülle (2) aus Kunststoffmaterial folgendes aufweist:
- wenigstens einen Schaltungschip (3), der auf einem Chipträgerrahmen (4) angebracht ist, und
- Wärmeabführelemente (15, 16) in Berührung mit dem Schaltungschip (3),
wobei das Verfahren folgende Schritte aufweist:
- Plazieren eines ersten Wärmeabführelements (15) in einem Gehäuse auf dem Boden (18) einer Aussparung (19), die in der unteren Hälfte (20) einer Spritzgießform für Kunststoffmaterial ausgebildet ist,
- Positionieren des Chipträgerrahmens (4) auf den Rändern der Aussparung (19) derart, daß ein leicht abgesenkter zentraler Bereich (6) des Chipträgerrahmens (4) mit dem ersten Wärmeabführelement (15) in Berührung tritt,
- Plazieren eines zweiten Wärmeabführelements (16) über dem ersten Wärmeabführelement (15) und Verbinden des zweiten Wärmeabführelements (16) mit dem ersten Wärmeabführelement (15) mittels Abstandszapfen (11),
- Plazieren einer oberen Formhälfte (21) über dem zweiten Wärmeabführelement (16) und Schließen der Form.

## Revendications

1. Boîtier de puce incorporant dans une coquille (2) de matière plastique de synthèse:
- au moins un circuit électronique sur une puce semiconductrice (3), et
- un dispositif de dissipation thermique (5), dans lequel le dispositif de dissipation thermique (5) comprend au moins deux éléments de dissipation thermique structurellement indépendants (15, 16) en contact mutuel,
caractérisé par une grille support de puce (4) sur laquelle la puce semiconductrice (1) est montée et qui est en contact avec le dispositif de dissipation thermique (5).

2. Boîtier de puce selon la revendication 1, caractérisé en ce que les deux éléments de dissipation thermique (15, 16) sont disposés sur des faces opposées de la grille support de puce (4).

3. Boîtier de puce selon la revendication 1, caractérisé en ce que des éléments de dissipation thermique (15, 16) sont disposés symétriquement par rapport à la grille support de puce (4).

4. Boîtier de puce selon la revendication 1, caractérisé en ce que les éléments de dissipation thermique (15, 16) sont connectés de façon séparable par des entretoises (11).

5. Boîtier de puce selon la revendication 4, caractérisé en ce que les entretoises (11) comprennent des demi-entretoises (12, 13) ayant des extrémités de formes adaptées et opposées en saillie à partir des éléments de dissipation thermique (15, 16), respectivement.

6. Boîtier de puce selon la revendication 5, caractérisé en ce que les demi-entretoises (12, 13) sont constituées d'une seule pièce dans chaque élément correspondant (15, 16).

7. Boîtier de puce selon la revendication 4, caractérisé en ce que les entretoises (11) traversent des trous (10) formées à travers la grille support de puce (4).

8. Boîtier de puce selon la revendication 4, caractérisé en ce que les entretoises (11) sont formées d'une seule pièce dans au moins l'un des deux éléments de dissipation thermique (15, 16).

9. Boîtier de puce selon la revendication 5, caractérisé en ce que les demi-entretoises (12, 13) ont des extrémités respectives auto-centreuses (14, 17) conformées de façon complémentaire.

10. Procédé pour augmenter la fiabilité d'un boîtier de puce semiconductrice incorporant, dans une coquille (2) de matière plastique de synthèse :
- au moins une puce de circuit (3) montée sur une grille support de puce (4), et
- des éléments de dissipation thermique (15, 16) en contact avec la puce (3) du circuit,
ce procédé comprenant les étapes suivantes :
- placer un premier élément de dissipation thermique (15) dans un boîtier sur le fond (18) d'une qualité (19) formée dans la seconde moitié (20) d'un moule d'injection de matière plastique de synthèse,
- disposer la grille support de puce (4) sur les bords de la cavité (19) de sorte qu'une partie centrale légèrement abaissée (6) de la grille support de puce (4) fait contact avec le premier élément de dissipation thermique (15),
- placer un second élément de dissipation thermique (16) au-dessus du premier élément de dissipation thermique (15) et le coupler à celui-ci par des entretoises (11), et
- placer un demi-moule supérieur (21) au-dessus du second élément de dissipation thermique (16) et fermer le moule.
